# EUROPEAN PATENT SPECIFICATION

(11) **EP 4 618 164 B1**
(45) Date of publication and mention of the grant of the patent: **17.06.2026**
(21) Application number: 23905662.5
(22) Date of filing: 30.11.2023
(51) Int. Cl.: H10F 71/00, H10F 77/20

(54) **PREPARATION METHOD FOR SOLAR CELL GRID LINE**
HERSTELLUNGSVERFAHREN FÜR SOLARZELLENGITTERLEITUNG
PROCÉDÉ DE PRÉPARATION DE LIGNE DE GRILLE DE CELLULE SOLAIRE

(30) Priority: 23.12.2022 CN 202211667531
(43) Date of publication of application: 17.09.2025
(73) Proprietor: Ja Solar Technology Yangzhou Co., Ltd., Yangzhou, Jiangsu 225131 (CN)
(72) Inventor: WANG, Yulin, Yangzhou, Jiangsu 225131 (CN); CHEN, Bin, Yangzhou, Jiangsu 225131 (CN); JIANG, Xiulin, Yangzhou, Jiangsu 225131 (CN)
(74) Representative: Sun, Yiming
(86) International application number: PCT/CN2023/135332
(87) International publication number: WO 2024/131495

(56) References cited:
- CN-A- 110 690 300
- CN-A- 111 009 588
- CN-A- 113 130 672
- CN-A- 115 083 659
- CN-A- 115 132 861
- CN-A- 115 132 861
- CN-A- 115 832 110
- CN-U- 217 993 923
- US-A1- 2020 211 729
- ADRIAN ADRIAN ET AL: "Finger Metallization Using Pattern Transfer Printing Technology for c-Si Solar Cell", IEEE JOURNAL OF PHOTOVOLTAICS, IEEE, vol. 10, no. 5, September 2020 (2020-09-01), pages 1290 - 1298, XP011805789, ISSN: 2156-3381, [retrieved on 20200819], DOI: 10.1109/JPHOTOV.2020.3007001

## Description

### Technical Field

The disclosure relates to the technical field of solar cell preparation, and in particular to a preparation method for a solar cell grid line.

### Background

Before a grid line is prepared on a cell precursor using laser transfer printing, a grooved area is usually formed on the surface of the cell precursor, and then the grid line may be formed in the grooved area by laser transfer printing technology. However, it is often difficult to reduce the width of the grooved area and the amount of the slurry used while ensuring that the grooved area is aligned with the slurry of the grid line, which makes it difficult to further increase the efficiency of solar cells, reduce the manufacturing cost of solar cells, and increase the manufacturing efficiency of solar cells.

Thus, a new preparation method for a solar cell grid line is urgently required.

CN115132861A discloses a solar cell grid line structure, a manufacturing method thereof and a solar cell, and relates to the photovoltaic field, and the manufacturing method of the solar cell grid line structure comprises the steps: providing a solar cell substrate which is provided with a first surface and a second surface which are opposite to each other; preparing a first grid line on the first surface by using the same equipment; preparing a second grid line on the second surface; the step of preparing the first grid line on the first face through the same equipment comprises the steps that laser grooving is conducted on the first face according to the pattern of the grid line carrier plate; filling the groove with slurry according to the pattern of the grid line carrier plate; transferring the slurry to the surface of the first surface of the solar cell by using laser; adjacent light spots of the laser are tangent, separated or intersected, and when the adjacent light spots are separated or intersected, the distance between the adjacent light spots is 0.5-50 [mu] m. The manufacturing process of the solar cell grid line structure is simplified, and the production cost is reduced.

### Summary

The present invention is set out in the set of appended claims.

In the preparation method for a solar cell grid line provided by the embodiment of the disclosure, the distance D between the areas to be grooved on the cell precursor (i.e., the distance relationship between the preset grid lines of the solar cell) is used as the design basis, the laser transfer printing substrate with the first transfer printing areas (including the conductive plate portions and the filling grooves) is also designed, and the cooperation of the laser transfer printing substrate and the laser device in terms of the movement direction and movement distance in the steps of performing laser grooving and performing grid line transfer printing is also taken into consideration, which ensures the consistency between the grooving width and the width of the transfer printed grid line while ensuring that the notch is aligned with the slurry for forming the grid line, thereby reducing the cell surface damage, reducing the recombination, increasing the efficiency of solar cells, saving the amount of the slurry for fabricating the grid line, reducing the fabrication cost of cells, and improving the performance of solar cells. The preparation method for a solar cell grid line provided by the embodiment of the disclosure may also ensure that the two steps of performing laser grooving and performing grid line laser transfer printing are completed in the same laser device, which reduces the investment cost of production equipment.

### Brief Description of the Drawings

In order to more clearly describe the technical solutions in the embodiments of the disclosure or the prior art, figures to be used in the descriptions of the embodiments or the prior art will be briefly introduced below. It is apparent that the figures in the descriptions below are only used for some embodiments of the disclosure, and those skilled in the art may also obtain other figures in accordance with these figures without making inventive efforts.
FIG. 1 is a schematic diagram of a structure of a laser transfer printing substrate according to an embodiment in a preparation method for a solar cell grid line provided by the disclosure;
FIG. 2 is a schematic diagram of an operation of step S30 according to an embodiment in the preparation method for a solar cell grid line provided by the disclosure;
FIG. 3 is a schematic diagram of an operation of step S40 according to an embodiment in the preparation method for a solar cell grid line provided by the disclosure;
FIG. 4 is a schematic diagram of an operation where a filling groove corresponds to a notch and laser acts on a slurry in the filling groove in step S50 according to an embodiment in the preparation method for a solar cell grid line provided by the disclosure;
FIG. 5 is a schematic diagram of an operation where the slurry in the filling groove is transferred to the notch using laser so as to complete transfer printing of one grid line in the step S50 according to an embodiment in the preparation method for a solar cell grid line provided by the disclosure;
FIG. 6 is a schematic diagram of an operation where a laser device is horizontally moved by a distance of D in a second direction in the step S50 according to an embodiment in the preparation method for a solar cell grid line provided by the disclosure;
FIG. 7 is a schematic diagram of another structure of the laser transfer printing substrate according to an embodiment in the preparation method for a solar cell grid line provided by the disclosure;
FIG. 8 is a schematic diagram of a further structure of the laser transfer printing substrate according to an embodiment in the preparation method for a solar cell grid line provided by the disclosure;
FIG. 9 is a schematic diagram of a still further structure of the laser transfer printing substrate according to an embodiment in the preparation method for a solar cell grid line provided by the disclosure;
FIG. 10 is a schematic diagram of a structure of the laser transfer printing substrate according to another embodiment in the preparation method for a solar cell grid line provided by the disclosure;
FIG. 11 is a schematic diagram of a flow of step S10' to step S40' according to another embodiment in the preparation method for a solar cell grid line provided by the disclosure;
FIG. 12 is a schematic diagram of a flow of step S50' to step S80' according to another embodiment in the preparation method for a solar cell grid line provided by the disclosure;
FIG. 13 is a schematic diagram of a three-dimensional structure of the laser transfer printing substrate according to another embodiment in the preparation method for a solar cell grid line provided by the disclosure;
FIG. 14 is a schematic diagram of another three-dimensional structure of the laser transfer printing substrate according to another embodiment in the preparation method for a solar cell grid line provided by the disclosure;
FIG. 15 is a schematic diagram of a grid line arrangement structure of a solar cell prepared by the preparation method for a solar cell grid line provided by the disclosure;
FIG. 16 is a schematic diagram of anther grid line arrangement structure of the solar cell prepared by the preparation method for a solar cell grid line provided by the disclosure.

### Explanations of reference signs:

10-laser transfer printing substrate; 11-conductive plate portion; 12-filling groove;
20-slurry; 21-grid line; 30-cell substrate; 31-film layer to be grooved; 311-notch; 40-laser device; 50-laser.
X-first direction; Y-second direction; Z-laser emission direction; A-first transfer printing area;
B-second transfer printing area; 60-positioning portion; 61-limiting groove; 62-connecting plate portion; 63-laser protection layer.

### Detailed Description

The technical solutions of the disclosure will be clearly and completely described below in combination with the figures. It is apparent that the described embodiments are part of the embodiments of the disclosure, rather than all of the embodiments thereof. All the other embodiments obtained by those skilled in the art based on the embodiments in the disclosure without making inventive efforts fall within the scope of protection of the disclosure.

In the descriptions of the disclosure, it should be noted that the orientations or positional relationships indicated by the terms "center", "up", "down", "left", "right", "vertical", "horizontal", "inside", "outside", and so on are based on the orientations or positional relationships as shown in the figures, and the terms are only used for facilitating the descriptions of the disclosure and simplifying the descriptions, rather than indicating or implying that the device or element referred to must have a specific orientation or be constructed and operated in a specific orientation, and thus cannot be understood as limitations on the disclosure. In addition, the terms "first", "second" and "third" are only used for descriptive purposes and cannot be understood as ones indicating or implying relative importance.

In the descriptions of the disclosure, it should be noted that, unless otherwise explicitly specified and limited, the terms "install", "connected to each other" and "connect" should be understood in a broad sense. For example, a fixed connection, a detachable connection, or an integral connection may be referred to; a mechanical connection or an electrical connection may be referred to; a direct connection to each other or an indirect connection to each other by an intermediate medium may be referred to, or a communication of interiors of two elements may be referred to. Those skilled in the art may understand the specific meanings of the aforesaid terms in the disclosure according to specific conditions.

In addition, the technical features involved in the different embodiments of the disclosure described below may be combined with each other as long as they do not conflict with each other.

The inventors have discovered in their long-term research on the preparation method for a solar cell grid line that generally, when laser transfer printing is used to prepare the grid line, it is often required to first perform laser grooving on a cell precursor to form a fixed laser grooving pattern, and then fabricate the grid line by a laser pattern transfer printing (PTP) technique on the fixed laser grooving pattern. Generally, the two steps of performing laser grooving and performing laser pattern transfer printing are required to be completed in different laser devices, which results in a large investment in production line equipment and a comparatively high production cost.

The laser pattern transfer printing technique is a material deposition technique. The laser pattern transfer printing technique generally uses a transparent film made of amorphous polyethylene terephthalate (APET) as a carrier base plate, uses a patterned rigid metal stamp to imprint the desired groove geometry into the carrier film, collects the film on a roller, and then installs it in a PTP (Pattern Transfer Printing) machine. Two metal scrapers are used to fill the groove with a slurry (e.g., a silver slurry, and an aluminum slurry) to form a laser transfer printing substrate, and then the slurry is transferred from the laser transfer printing substrate to a target solar cell precursor using laser.

Generally, in the process of preparing a cell grid using the laser pattern transfer printing, laser grooving is performed first, then the grid line is transfer printed to the fixed laser grooving pattern by laser, and machine vision positioning is required to be used before grid line printing is performed. Two manners are generally used to meet requirements for alignment and matching between the notch of the grooved area and the transfer printed grid line in the solar cell. The first manner is to increase the notch width of the grooved area so that the notch width is much larger than the width of the transfer printed grid line to achieve the alignment. The first manner often results in a comparatively large damaged area of the grooved film layer, which deteriorates the passivation effect of the cell surface and reduces the open circuit voltage of the solar cell. The second manner is to keep the notch width of the grooved area unchanged and increase the width of the transfer printed grid line, which manner increases the amount of the slurry used, thereby resulting in an increase in the fabrication cost of the grid line, and also increases obstruction on the surface of the solar cell, thereby resulting in a decrease in the light-receiving area of the solar cell and a decrease in the short-circuit current of the solar cell.

In order to further increase the efficiency of solar cells and reduce the amount of the slurry used, the most effective method is to make the width of the laser grooving be equivalent to the width of the transfer printed grid line. However, in the process of preparing the grid line on the cell precursor using laser transfer printing, it is often difficult to reduce the width of the grooved area and the amount of the slurry used while ensuring that the grooved area is aligned with the slurry of the grid line, which makes it difficult to further increase the efficiency of solar cells, reduce the manufacturing cost of solar cells, and increase the manufacturing efficiency of solar cells.

In view of the discovery and research on the aforesaid technical problems, the disclosure is proposed.

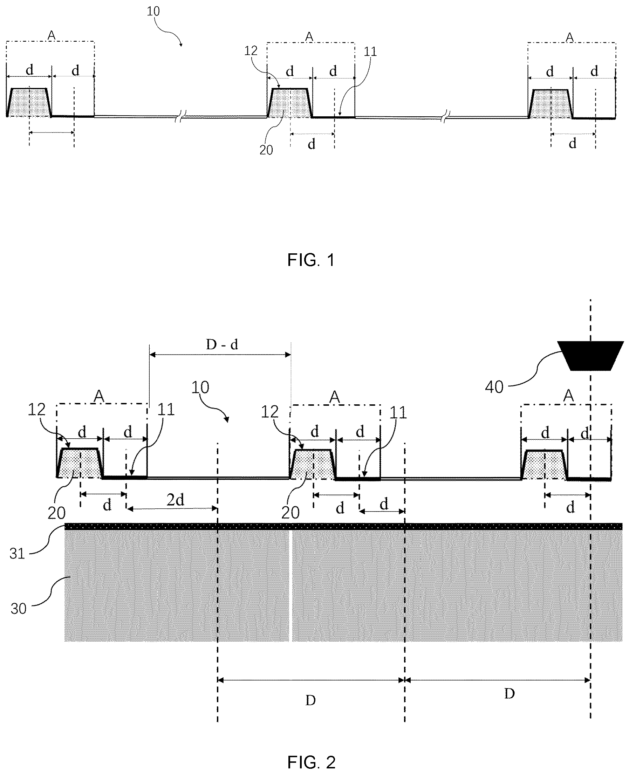

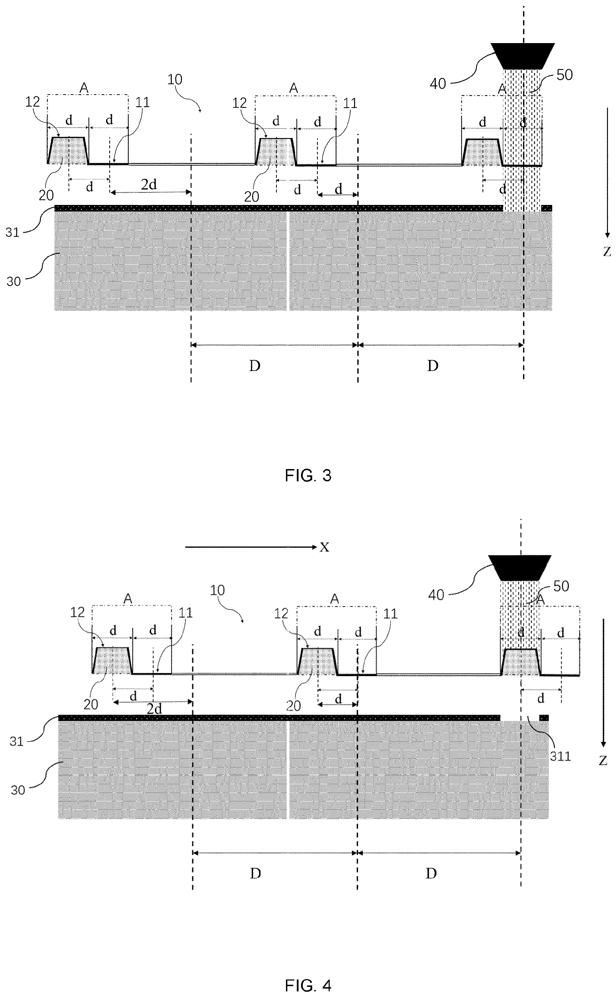

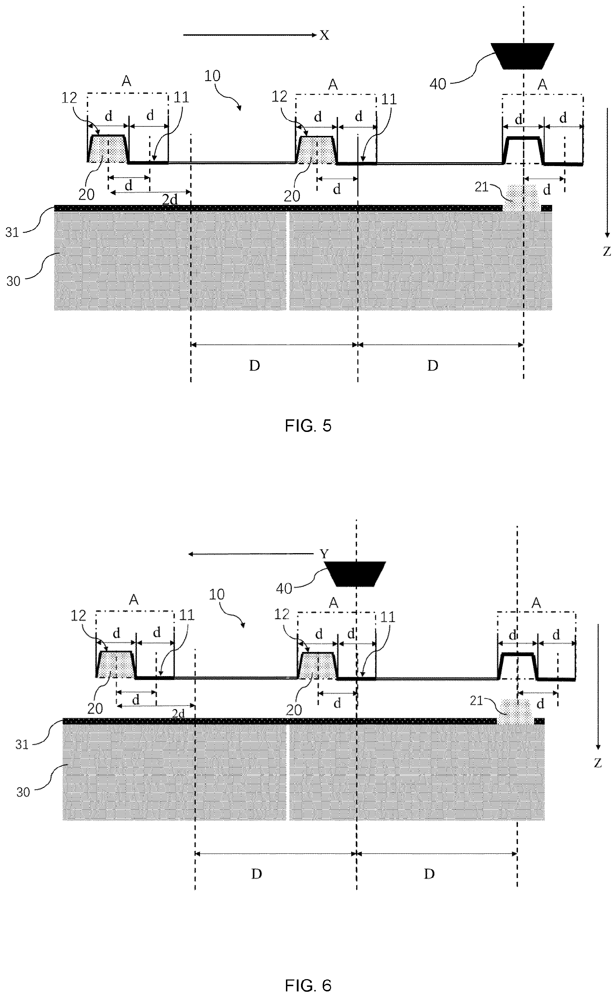

As shown in FIG. 1 to FIG. 6, the embodiment of the disclosure provides a preparation method for a solar cell grid line 21, comprising:
S10: providing a cell precursor having a film layer 31 to be grooved, which includes areas to be grooved for forming grid lines 21, the plurality of areas to be grooved being arranged at intervals by a distance of D between the respective center lines thereof;
S20: providing a laser transfer printing substrate 10, which includes a plurality of first transfer printing areas A arranged at intervals by a distance of k, wherein k is equal to D-d, k>0, each of the first transfer printing areas has a conductive plate portion 11 and a filling groove 12 that are connected to each other and both have a width of d, and the filling groove 12 is filled with a slurry 20 and is arranged to protrude relative to a plane where the conductive plate portion 11 is located;
S30: aligning the center line of one conductive plate portion 11 with the center line of one of the areas to be grooved;
S40: performing laser grooving, wherein laser 50 (a first laser beam is emitted in this step) emitted by a laser device 40 grooves the area to be grooved via the conductive plate portion 11 so as to form a notch 311 having a width of d in the film layer 31 to be grooved, and the cell precursor and the laser transfer printing substrate 10 are arranged at intervals in parallel with each other in a laser emission direction Z;
S50: performing grid line 21 transfer printing, wherein the laser transfer printing substrate 10 is horizontally moved by a distance of d in a first direction X so that the filling groove 12 corresponds to the notch 311, the slurry 20 in the filling groove 12 is transferred to the notch 311 using laser 50 so as to complete transfer printing of one grid line 21, and the laser device 40 is horizontally moved by a distance of D in a second direction Y; and
repeating the steps of performing laser grooving and performing grid line 21 transfer printing till fabrication of all the grid lines 21 corresponding to the areas to be grooved in the film layer 31 to be grooved of the cell precursor is completed, wherein the second direction Y is opposite to the first direction X, and both of the first and directions are perpendicular to the laser emission direction Z.

As shown in FIG. 1 to FIG. 6, the center line of the conductive plate portion 11 is a thin dotted line perpendicular to the plane where the conductive plate portion 11 is located, and the vertical distances from both ends of the conductive plate portion 11 in the width direction to the center line of the conductive plate portion 11 are equal. The center line of the filling groove 12 is a thin dotted line perpendicular to the plane where the conductive plate portion 11 is located, and the distances from both ends of the filling groove 12 in the width direction to the center line of the filling groove 12 are equal. The distance between the center line of the conductive plate portion 11 and the center line of the filling groove 12 is d. The width of the area to be grooved is equal to the width of the notch 311 after the laser grooving is performed. In the process of preparing a solar cell grid, the center line of the area to be grooved is a thick dotted line perpendicular to the film layer 31 to be grooved and the plane where the conductive plate portion 11 is located, and the distances from both ends of the area to be grooved in the width direction to the center line of the area to be grooved are equal.

In the preparation method for a solar cell grid provided by the embodiment of the disclosure, when the laser transfer printing substrate 10 is moved by a distance of d each time to complete the transfer printing of one grid line 21, in the second direction Y in which the laser device 40 is moved, the area to be grooved adjacent to the grid line 21 is opposite to the guide plate of the laser transfer printing substrate 10, so that the steps of performing grid line 21 transfer printing and performing laser grooving can follow each other so as to increase the preparation efficiency of the grid line 21.

In the preparation method for a solar cell grid line 21 provided in the embodiment of the disclosure, the distance D between the areas to be grooved on the cell precursor (i.e., the distance relationship between the preset grid lines 21 of the solar cell) is used as the design basis, the laser transfer printing substrate 10 with the first transfer printing areas A (including the conductive plate portions 11 and the filling grooves 12 both having a width of d) is also designed, and the cooperation of the laser transfer printing substrate 10 and the laser device 40 in terms of the movement direction and movement distance in the steps of performing laser grooving and performing grid line 21 transfer printing is also taken into consideration, which ensures the consistency between the grooving width and the width of the transfer printed grid line 21 while ensuring that the notch 311 is aligned with the slurry 20 for forming the grid line 21, thereby reducing the cell surface damage, reducing the surface recombination, increasing the efficiency of solar cells, saving the amount of the slurry 20 for fabricating the grid line 21, and reducing the fabrication cost of cells. When the width of the transfer printed grid line 21 is reduced, the light-receiving area of the cell will be increased, which increases the short-circuit current of the solar cell and increases the efficiency of solar cells. The preparation method for a solar cell grid line 21 provided by the embodiment of the disclosure may also ensure that the two steps of performing laser grooving and performing grid line 21 transfer printing are completed in the same laser devices, which reduces the investment cost of production equipment.

In some optional embodiments of the disclosure, the width of the filling grove 12 refers to the width of the grooved end of the filling groove 12 on the plane where the conductive plate portion 11 is located.

In some optional embodiments of the disclosure, the cell precursor includes a cell substrate 30 and a film layer 31 to be grooved arranged on at least one side of the silicon-based substrate. In some examples of these embodiments, the film layer 31 to be grooved is a passivation layer of a solar cell. In some examples, the cell substrate 30 includes a silicon base and an emitting electrode, the silicon base is monocrystalline silicon, polycrystalline silicon, microcrystalline silicon or amorphous silicon, and the emitting electrode is a silicon material with a doping type opposite to that of the silicon base. In some examples, the film layer to be grooved includes at least one of silicon nitride, aluminum oxide, silicon oxynitride, silicon oxide, and aluminum nitride.

In some optional embodiments of the disclosure, in the step of aligning the center line of one conductive plate portion 11 with the center line of one area to be grooved, the center line of the conductive plate portion 11 of the laser transfer printing substrate 10 closest to its own first side edge is made to correspond to the center line of the area to be grooved of the cell precursor closest to its own second side edge, wherein the first side edge and the second side edge belong to the same side.

In some optional embodiments of the disclosure, in the step of performing laser grooving, the laser 50 (the emitted first laser beam) emitted by the laser device 40 grooves the area to be grooved via the conductive plate portion 11, that is, the laser 50 grooves the area to be grooved based on the position and width of the conductive plate portion 11. Since the conductive plate portion 11 and the filling groove 12 both have a width of d, grooving is performed by the laser 50 based on the conductive plate portion 11 to form a notch having a width of d. Besides, the filling groove 12 has a width of d, so that the width of the transfer printed grid line 21 is equal to the grooving width.

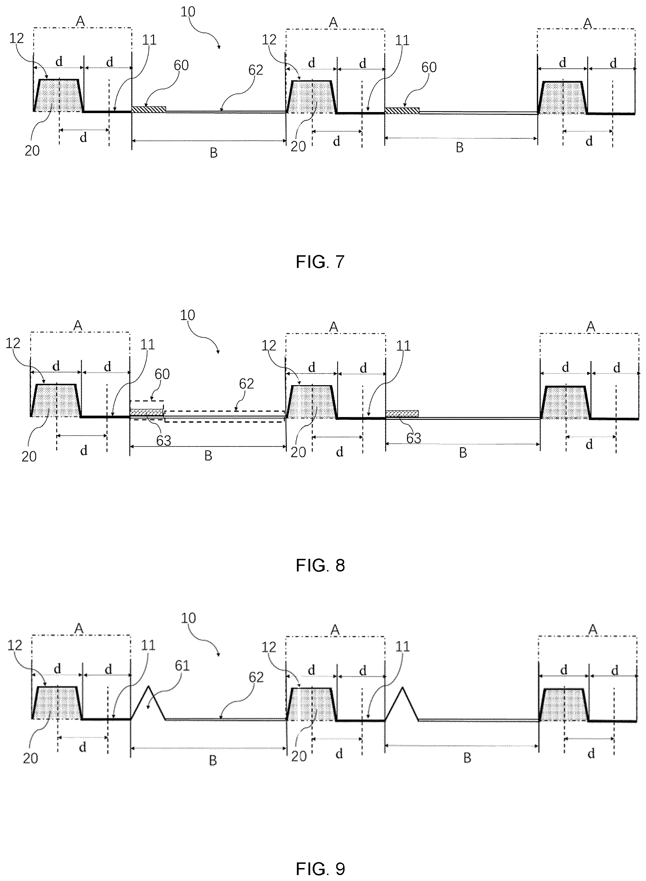

As shown in FIG. 7, in some optional embodiments of the disclosure, in the step of providing a laser transfer printing substrate 10, the laser transfer printing substrate 10 further includes:
a second transfer printing area B, which is located between the two adjacent first transfer printing areas A and connected to the first transfer printing areas A, wherein the second transfer printing area B is provided therein with a positioning portion 60, the positioning portion 60 and the filling groove 12 are arranged opposite to each other on both sides of the conductive plate portion 11 and connected to the conductive plate portion 11, and the positioning portion 60 is used to assist laser 50 alignment and prevent the laser 50 from acting on an area not to be grooved of the film layer 31 to be grooved.

In some optional embodiments of the disclosure, the step S30 of aligning the center line of one conductive plate portion 11 with the center line of one area to be grooved comprises:
Step S31: arranging benchmarks on both side edges of the area to be grooved, and acquiring position information of the area to be grooved in accordance with the benchmarks. In some examples, a plurality of laser patterning system cameras are used to obtain the position information of the benchmarks by photographing, and the position information of the benchmarks is sent to a controller.

Step S32: controlling the laser device 40 to move relative to the cell precursor in accordance with the position information of the area to be grooved till a second laser beam emitted by the laser device 40 covers one area to be grooved, alignment of the laser device 40 with one area to be grooved in the cell precursor is completed, the beam widths of the first laser beam (the laser 50 emitted by the emitter for grooving) and the second laser beam are equal to the width of the area to be grooved, the power of the first laser beam is greater than the power of the second laser beam, and the second laser beam does not act on the film layer 31 to be grooved. In these examples, the first laser beam may act on the film layer 31 to be grooved, that is, when the first laser beam with a comparatively high energy density is irradiated to the film layer 31 to be grooved, the film layer 31 to be grooved may absorb the energy of the first laser beam so as to produce melting, ablation and evaporation, thereby achieving the purpose of removing the film layer. In the step S40, the laser emitter emits the first laser beam. The second laser beam does not act on the film layer to be grooved, that is, the energy density of the second laser beam is lower than that of the first laser beam, and the area of the film layer to be grooved irradiated by the second laser beam will not be thinned or even perforated. The parameters of the first laser beam and the second laser beam may be set in accordance with the specific material and thickness of the film layer to be grooved. In the step S30, the laser device emits the second laser beam.

Step S33: locating one conductive plate portion 11 in the laser transfer printing substrate between the laser device 40 and the cell precursor (including the cell substrate 30 and the film layer 31 to be grooved), emitting the second laser beam emitted by the laser device 40 via the laser transfer printing substrate 10 at the same time, and controlling the laser transfer printing substrate 10 to move relative to the cell precursor in accordance with laser transmittance of an area above the area to be grooved aligned with the laser device 40 and/or laser reflectivity between the laser transfer printing substrate 10 and the laser device 40 till the center line of one conductive plate portion 11 is aligned with the center line of one area to be grooved.

In some optional embodiments of the disclosure, the second transfer printing area B further includes a connecting plate portion 62, which connects the positioning portion 60 and the filling groove 12 in the adjacent first transfer printing area A.

With further reference to FIG. 7, in some optional embodiments of the disclosure, the positioning portion 60 may include a laser protection material. The laser protection material is a material having comparative low transmittance and thermal stability with respect to the laser 50 for laser grooving, and the laser protection material obstructs the propagation of the laser beam. In some examples of these embodiments, a transparent film made of amorphous polyethylene terephthalate is doped with nitrogen-aluminum co-doped hydrophobic carbon dots for laser 50 protection. In some other examples of these embodiments, the positioning portion 60 is formed using a polymethyl methacrylate film doped with the nitrogen-aluminum co-doped hydrophobic carbon dots. In the second transfer printing area B, the positioning portion 60 is connected to the connecting plate portion 62.

In the aforesaid embodiments, the positioning portion 60 obstructs the transmission of the second laser beam through the laser transfer printing substrate 10, and the filling groove 12, which is filled with the slurry 20, also obstructs the transmission of the second laser beam through the laser transfer printing substrate 10. Thus, in these embodiments, there is the step S33: locating one conductive plate portion 11 in the laser transfer printing substrate between the laser device 40 and the cell precursor (including the cell substrate 30 and the film layer 31 to be grooved), emitting the second laser beam emitted by the laser device 40 via the laser transfer printing substrate 10 at the same time, and controlling the laser transfer printing substrate 10 to move relative to the cell precursor in accordance with laser transmittance of an area above the area to be grooved aligned with the laser device 40 till the center line of one conductive plate portion 11 is aligned with the center line of one area to be grooved. When the center line of the conductive plate portion 11 in the laser transfer printing substrate 10 has not yet been aligned with the center line of one area to be grooved, due to the obstruction of the positioning portion 60 and the filling groove 12, at least a part of the second laser beam is blocked and fails to pass through the conductive plate portion 11 via the laser transfer printing substrate 11 to reach the area above the area to be grooved aligned with the laser device 40, so the transmittance of the second laser is reduced, and when the transmittance of the second laser is not affected, it indicates that the center line of one conductive plate portion 11 is aligned with the center line of one area to be grooved.

As shown in FIG. 8, in some optional embodiments of the disclosure, the positioning portion 60 includes a laser protection layer 63 covering the base plate of the laser transfer printing substrate 10. In some examples of these embodiments, the base plate of the laser transfer printing substrate 10 is formed by a transparent film made of amorphous polyethylene terephthalate, and the laser protection layer 63 has an absorption or reflection effect on the laser beam, especially the first laser beam 50 for laser grooving, so as to block the first laser beam 50 on the laser protection layer 63 to prevent the first laser beam 50 from further propagating downwards to cause a damage to a non-grooved area of the film layer 31 to be grooved.

In some examples of the aforesaid embodiments, the material of the laser protection layer 63 includes any of indanthrene compounds, C60 compounds, metal phthalocyanine organic materials, zinc selenide, aluminum, silver, SiO₂, TiO₂, Al₂O₃, Ta₂O₅, MgF₂, LaF₃, and AlF₃.

In the aforesaid embodiments, when the laser protection layer 63 of the positioning portion 60 has an absorption effect on the laser beam, before the center line of one conductive plate portion 11 is not aligned with the center line of one area to be grooved, the positioning portion 60 obstructs the transmission of the laser beam through the laser transfer printing substrate 10, and the filling groove 12, which is filled with the slurry 20, also obstructs the transmission of the laser beam through the laser transfer printing substrate 10. Thus, in these embodiments, there is the step S33: locating one conductive plate portion 11 in the laser transfer printing substrate between the laser device 40 and the cell precursor (including the cell substrate 30 and the film layer 31 to be grooved), emitting the laser beam emitted by the laser device 40 via the laser transfer printing substrate 10 at the same time, and controlling the laser transfer printing substrate 10 to move relative to the cell precursor in accordance with laser transmittance of an area above the area to be grooved aligned with the laser device 40 till the center line of one conductive plate portion 11 is aligned with the center line of one area to be grooved.

In the aforesaid embodiments, when the laser protection layer 63 of the positioning portion 60 has a reflection effect on the laser beam 50, before the center line of one conductive plate portion 11 is not aligned with the center line of one area to be grooved, the positioning portion 60 obstructs the transmission of the laser beam through the laser transfer printing substrate 10 and reflecting the laser beam, and the filling groove 12, which is filled with the slurry 20, also obstructs the transmission of the laser beam through the laser transfer printing substrate 10. Thus, in these embodiments, there is the step S33: locating one conductive plate portion 11 in the laser transfer printing substrate between the laser device 40 and the cell precursor (including the cell substrate 30 and the film layer 31 to be grooved), emitting the laser beam emitted by the laser device 40 via the laser transfer printing substrate 10 at the same time, and controlling the laser transfer printing substrate 10 to move relative to the cell precursor in accordance with laser transmittance of an area above the area to be grooved aligned with the laser device 40 and/or laser reflectivity between the laser transfer printing substrate and the laser device till the center line of one conductive plate portion 11 is aligned with the center line of one area to be grooved.

As shown in FIG. 9, in some optional embodiments of the disclosure, the positioning portion 60 includes a limiting groove 61, which is arranged to protrude relative to the conductive plate portion 11, and the protruding surface of the limiting groove 61 is covered with a laser reflection layer. The laser reflection layer includes at least one of aluminum, silver, gold and copper, and is a thin layer made of metal.

In the aforesaid embodiments, when the laser reflection layer of the positioning portion 60 has a reflection effect on the laser beam 50, before the center line of one conductive plate portion 11 is not aligned with the center line of one area to be grooved, the positioning portion 60 obstructs the transmission of the laser beam through the laser transfer printing substrate 10, due to the protrusion of the limiting groove 61, the incident laser is reflected to the side of the exit area of the laser 50 at a certain angle to the horizontal plane where the conductive plate portion 11 is located, and the filling groove 12, which is filled with the slurry 20, obstructs the transmission of the laser beam through the laser transfer printing substrate 10. Thus, in these embodiments, there is the step S33: locating one conductive plate portion 11 in the laser transfer printing substrate between the laser device 40 and the cell precursor (including the cell substrate 30 and the film layer 31 to be grooved), emitting the laser beam emitted by the laser device 40 via the laser transfer printing substrate 10 at the same time, and controlling the laser transfer printing substrate 10 to move relative to the cell precursor in accordance with laser transmittance of an area above the area to be grooved aligned with the laser device 40 and/or laser reflectivity between the laser transfer printing substrate and the laser device till the center line of one conductive plate portion 11 is aligned with the center line of one area to be grooved. A laser beam collector may be arranged in the exit area of the laser 50 to receive the reflected laser, and the laser reflectivity between the laser transfer printing substrate and the laser device may be calculated in accordance with the received reflected laser and the laser 50 emitted by the laser device 40.

In these embodiments, the limiting groove 61 is arranged to help improve the alignment of the positions and widths between the laser 50 and the conductive plate portion 11 in the step S40 of performing laser grooving, improve the precision of the laser grooving, ensure the quality of the preparation of the solar cell grid line 21 and the quality of the final solar cell, and also prevent the laser 50 from acting on an area not to be grooved of the film layer 31 to be grooved, thereby reducing the cell surface damage and reducing the recombination.

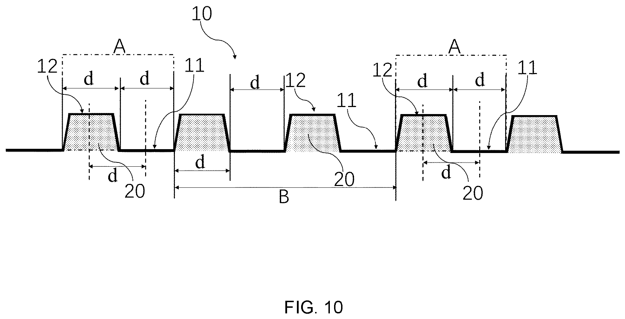

As shown in Figure 10, in some embodiments of the disclosure, the positioning portion 60 is the filling groove 12 filled with the slurry 20, the second transfer printing area B further includes the conductive plate portion 11, and the plurality of conductive plate portions 11 and filling grooves 12 filled with the slurry 20 are alternately arranged in the second transfer printing area B, wherein D=(2n+1)×d, and n is a positive integer greater than 1.

In these embodiments, the filling groove 12 filled with the slurry 20 in the second transfer printing area B may serve as the positioning portion 60 when the first transfer printing area A is used to prepare the cell grid line 21 of the first cell precursor. A plurality of conductive plate portions 11 and filling grooves 12 filled with the slurry 20 are alternately arranged in the second transfer printing area B, wherein D=(2n+1)×d, and n is a positive integer greater than 1. After the completion of the preparation of the cell grid line 21 of the first cell precursor (i.e., the slurry 20 of the filing groove 12 in the first transfer printing area A of the laser transfer printing substrate 10 is completely transfer printed to the first cell precursor), the filling groove 12 in the second transfer printing area B in the same laser transfer printing substrate 10 may be used to prepare the grid line 21 for a new second cell precursor to be printed with the grid line 21 in the same laser devices using the preparation method for a solar cell grid line 21 provided by the embodiments of the disclosure. In these embodiments, the utilization rate of the laser transfer printing substrate 10 is increased, the number of times the laser transfer printing substrate 10 is replaced is reduced, the preparation time before the preparation of the grid line 21 is shortened, the preparation efficiency of the grid line 21 is greatly increased, and the preparation cost of the grid line 21 is reduced.

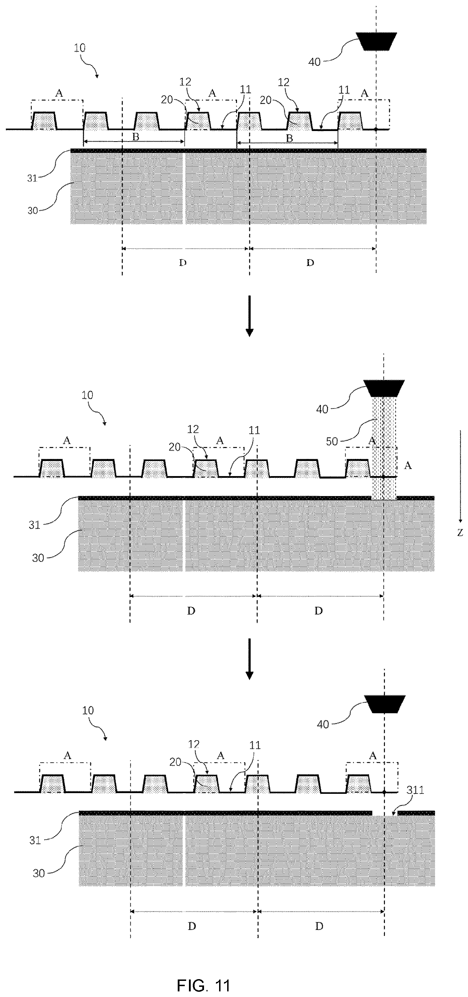

The process of preparing the solar cell grid line 21 using the laser transfer printing substrate 10 in the aforesaid embodiments is specifically described below in combination with FIG. 11 to FIG. 16.

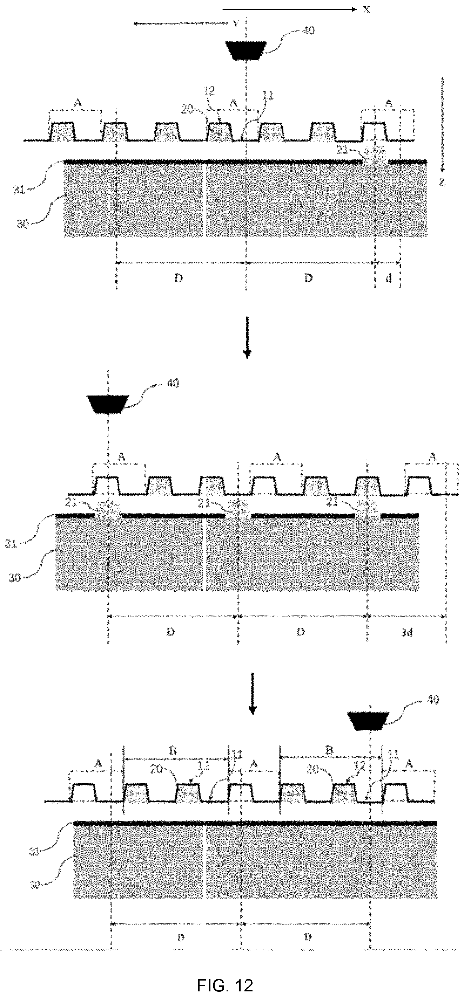

As shown in FIG. 11 and FIG. 12, another embodiment of the disclosure provides a preparation method for a solar cell grid line 21, comprising:
S10': providing a first cell precursor having a film layer 31 to be grooved, which includes areas to be grooved for forming grid lines 21, the plurality of areas to be grooved being arranged at intervals by a distance of D between the respective center lines thereof;
S20': providing a laser transfer printing substrate 10, which includes a plurality of first transfer printing areas A arranged at intervals by a distance of k, wherein k is equal to D-d, k>0, each of the first transfer printing areas A has a conductive plate portion 11 and a filling groove 12 that are connected to each other and both have a width of d, the filling groove 12 is filled with a slurry 20 and is arranged to protrude relative to a plane where the conductive plate portion 11 is located, the laser transfer printing substrate 10 further includes a second transfer printing area B, which is located between the two adjacent first transfer printing areas A and connected to the first transfer printing areas A, the second transfer printing area B is provided therein with a positioning portion 60, the positioning portion 60 and the filling groove 12 are arranged opposite to each other on both sides of the conductive plate portion 11 and connected to the conductive plate portion 11, the positioning portion 60 is the filling groove 12 filled with the slurry 20, the second transfer printing area B further includes the conductive plate portion 11, and the plurality of conductive plate portions 11 and filling grooves 12 filled with the slurry 20 are alternately arranged in the second transfer printing area B, wherein D=(2n+1)×d, and n is a positive integer greater than 1;
S30': aligning the center line of one conductive plate portion 11 with the center line of one area to be grooved;
S40': performing laser grooving, wherein laser 50 emitted by a laser device 40 grooves the area to be grooved via the conductive plate portion 11 so as to form a notch 311 having a width of d in the film layer 31 to be grooved, and the cell precursor and the laser transfer printing substrate 10 are arranged at intervals in parallel with each other in a laser emission direction Z;
S50': performing grid line 21 transfer printing, wherein the laser transfer printing substrate 10 is horizontally moved by a distance of d in a first direction X so that the filling groove 12 corresponds to the notch 311, the slurry 20 in the filling groove 12 is transferred to the notch 311 using laser 50 so as to complete transfer printing of one grid line 21, and the laser device 40 is horizontally moved by a distance of D in a second direction Y; and
repeating the steps of performing laser grooving and performing grid line 21 transfer printing till fabrication of all the grid lines 21 corresponding to the areas to be grooved in the film layer 31 to be grooved of the cell precursor is completed, wherein the second direction Y is opposite to the first direction X, and both of the first and directions are perpendicular to the laser emission direction Z.
S60': providing a second cell precursor (a new cell precursor as compared to the first cell precursor) having a film layer 31 to be grooved, which includes areas to be grooved for forming grid lines 21, the plurality of areas to be grooved being arranged at intervals by a distance of D between the respective center lines thereof;
S70': providing the laser transfer printing substrate 10 on which fabrication of the grid line of the first cell precursor has been completed using the slurry in the first transfer printing area A and which is in an available state;
S80': aligning the center line of one conductive plate portion 11 in the second transfer printing area B of the laser transfer printing substrate 10 in the available state with the center line of one area to be grooved in the second cell precursor (the new cell precursor); and
repeating the aforesaid step S40' of performing laser grooving and the aforesaid step S50' of performing grid line 21 transfer printing till fabrication of all the grid lines corresponding to the areas to be grooved in the film layer 31 to be grooved of the second cell precursor is completed, wherein the second direction Y is opposite to the first direction X, and both of the first and directions are perpendicular to the laser emission direction Z.

In some optional embodiments of the disclosure, the preparation method further comprises, after the step 80', step S90': determining whether the filling groove 12 filled with the slurry exists in each of the second transfer printing areas B of the laser transfer printing substrate 10, if it is determined that the filling groove 12 filled with the slurry exists, the laser transfer printing substrate 10 is still in the available state and is continued to be used to fabricate the grid lines of the new cell precursor, and if it is determined that the filling groove 12 filled with the slurry does not exist, the laser transfer printing substrate 10 is replaced. To be specific, whether the filling groove 12 filled with the slurry exists in the second transfer printing area B may be determined by the reflectivity or transmittance of the laser. Alternatively, an image may be obtained by photographing with a photographing apparatus to thereby determine whether the filling groove 12 filled with the slurry exists in the second transfer printing area B.

In these embodiments, a single laser transfer printing substrate 10 may be used to fabricate grid lines 21 of a plurality of cell precursors, which avoids the problem of a high cost and a low preparation efficiency caused by the frequent replacement of the laser transfer printing substrate 10.

In some optional embodiments of the disclosure, in a direction in which the filling groove protrudes, the notch size of the filling groove is greater than or equal to the sizes of the other positions of the filling groove. In these embodiments, the notch size of the filling groove is greater than or equal to the sizes of the other positions of the filling groove, which saves the slurry for making the grid line 21 and reduces the preparation cost of the solar cell grid line while ensuring that the grid line formed by the slurry is adapted to the notch width of the film layer 31 to be grooved.

In some optional embodiments of the disclosure, in the step of providing a laser transfer printing substrate 10, the cross-sectional shape of the filling groove 12 is selected from any of a trapezoid, a rectangle and a triangle.

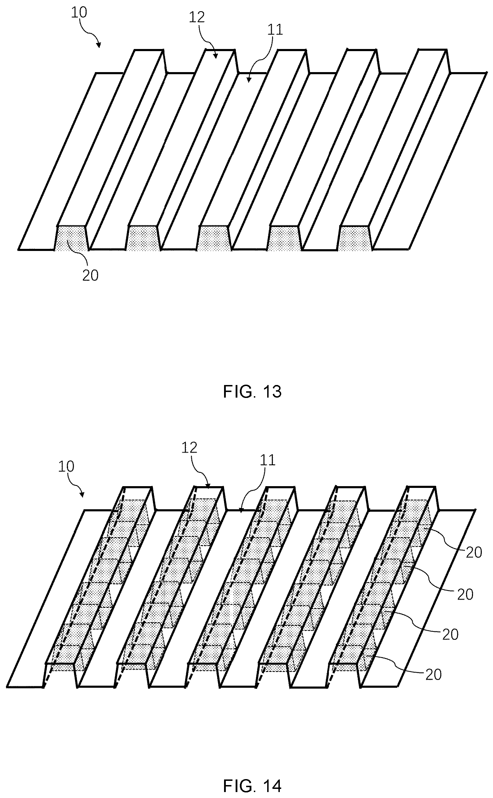

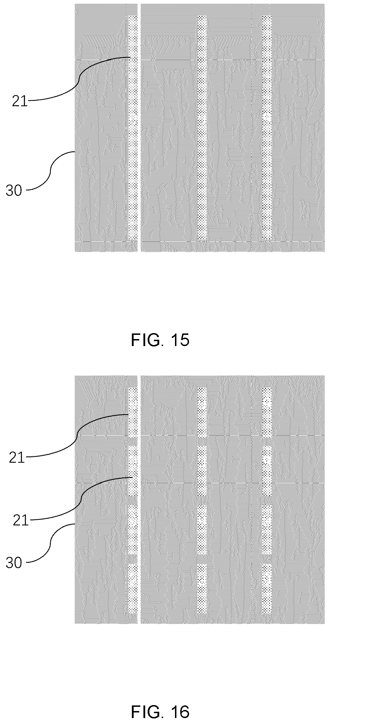

In some optional embodiments of the disclosure, in the step of providing a laser transfer printing substrate 10, as shown in FIG. 13, the filling groove 12 is continuously filled with the slurry 20. In the step of performing laser grooving, the notch 311 is a continuous notch 311. As shown in FIG. 15, a continuous notch 311 is opened on the film layer 30 to be grooved, and the slurry 20 continuously filled in the filling groove 12 as shown in FIG. 13 is correspondingly transfer printed to the cell precursor via the step of performing laser transfer printing to form the continuous and uninterrupted grid line 21 as shown in FIG. 15.

In some other optional embodiments of the disclosure, in the step of providing a laser transfer printing substrate 10, as shown in FIG. 14, the filling groove 12 is intermittently filled with the slurry 20. In the step of performing laser grooving, the notch 311 is an intermittent notch 311. As shown in FIG. 16, the intermittent notch is opened on the film layer 30 to be grooved, and the slurry 20 intermittently filled in the filling groove 12 as shown in FIG. 14 is correspondingly transfer printed to the cell precursor via the step of performing laser transfer printing to form the intermittent grid line 21. In some optional embodiments of the disclosure, the value range of d is 5 µm-80 µm, for example, the value of d may be 5 µm, 10 µm, 15 µm, 20 µm, 25 µm, 30 µm, 35 µm, 40 µm, 45 µm, 50 µm, 55 µm, 60 µm, 65 µm, 70 µm, 75 µm or 80 µm, etc.

The descriptions above are only specific implementation modes of the disclosure, but the scope of protection of the disclosure is not limited thereto, and any changes or substitutions that may be readily conceived by technicians familiar with the technical field within the technical scope disclosed in the disclosure should be included in the scope of protection of the disclosure. Thus, the scope of protection of the disclosure should be based on the scopes of protection of the claims.

## Claims

1. A preparation method for a solar cell grid line, comprising:
providing a cell precursor having a film layer (31) to be grooved, which includes areas to be grooved for forming grid lines (21), the plurality of areas to be grooved being arranged at intervals by a distance of D between the respective center lines thereof;
providing a laser transfer printing substrate (10), which includes a plurality of first transfer printing areas (A) arranged at intervals by a distance of k, wherein k is equal to D-d, k>0, each of the first transfer printing areas has a conductive plate portion (11) and a filling groove (12) that are connected to each other and both have a width of d, and the filling groove is filled with a slurry (20) and is arranged to protrude relative to a plane where the conductive plate portion is located;
aligning the center line of one of the conductive plate portions with the center line of one of the areas to be grooved;
performing laser grooving, wherein a first laser beam emitted by a laser device (40) grooves the area to be grooved via the conductive plate portion so as to form a notch (311) having a width of d in the film layer to be grooved, the cell precursor and the laser transfer printing substrate being arranged at intervals in parallel with each other in a laser emission direction (Z);
performing grid line transfer printing, wherein the laser transfer printing substrate is horizontally moved by a distance of d in a first direction (X) so that the filling groove corresponds to the notch, the slurry in the filling groove is transferred to the notch using the first laser beam emitted by the laser device (40) so as to complete transfer printing of one grid line, and the laser device is horizontally moved by a distance of D in a second direction (Y); and
repeating the steps of performing laser grooving and performing grid line transfer printing till fabrication of all the grid lines corresponding to the areas to be grooved in the film layer to be grooved of the cell precursor is completed, wherein the second direction is opposite to the first direction, and both of the first and directions are perpendicular to the laser emission direction.

2. The preparation method according to claim 1, wherein in the step of providing a laser transfer printing substrate, the laser transfer printing substrate further includes:
a second transfer printing area (B), which is located between the two adjacent first transfer printing areas and connected to the first transfer printing areas, wherein the second transfer printing area is provided therein with a positioning portion (60), the positioning portion and the filling groove are arranged opposite to each other on both sides of the conductive plate portion and connected to the conductive plate portion, and the positioning portion is used to assist laser alignment and prevent the laser from acting on an area not to be grooved of the film layer to be grooved.

3. The preparation method according to claim 2, wherein the step (S30) of aligning the center line of one of the conductive plate portions with the center line of one of the areas to be grooved comprises:
arranging benchmarks on both side edges of the area to be grooved, and acquiring position information of the area to be grooved in accordance with the benchmarks;
controlling the laser device to move relative to the cell precursor in accordance with the position information of the area to be grooved till a second laser beam emitted by the laser device covers one of the areas to be grooved, alignment of the laser device with one of the areas to be grooved in the cell precursor is completed, the beam widths of the first laser beam and the second laser beam are equal to the width of the area to be grooved, the power of the first laser beam is greater than the power of the second laser beam, and the second laser beam does not act on the film layer to be grooved; and
locating one of the conductive plate portions in the laser transfer printing substrate between the laser device and the cell precursor, emitting the second laser beam emitted by the laser device via the laser transfer printing substrate at the same time, and controlling the laser transfer printing substrate to move relative to the cell precursor in accordance with laser transmittance of an area above the area to be grooved aligned with the laser device and/or laser reflectivity between the laser transfer printing substrate and the laser device till the center line of one of the conductive plate portions is aligned with the center line of one of the areas to be grooved.

4. The preparation method according to claim 2, wherein
the second transfer printing area further includes a connecting plate portion (62), which connects the positioning portion and the filling groove in the adjacent first transfer printing area.

5. The preparation method according to any of claims 2 to 4, wherein
the positioning portion includes a laser protection material.

6. The preparation method according to any of claims 2 to 4, wherein
the positioning portion includes a laser protection layer (63) covering a base plate of the laser transfer printing substrate.

7. The preparation method according to any of claims 2 to 4, wherein
the positioning portion includes a limiting groove (61), which is arranged to protrude relative to the conductive plate portion, and the protruding surface of the limiting groove is covered with a laser reflection layer.

8. The preparation method according to claim 2, wherein
the positioning portion is the filling groove filled with the slurry, the second transfer printing area further includes the conductive plate portion, and a plurality of the conductive plate portions and the filling grooves filled with the slurry are alternately arranged in the second transfer printing area, wherein D=(2n+1)×d, and n is a positive integer greater than 1.

9. The preparation method according to claim 8, wherein the value range of d is 5 µm-80 µm.

10. The preparation method according to claim 8, wherein after the fabrication of all the grid lines corresponding to the areas to be grooved in the film layer to be grooved of the cell precursor is completed, the preparation method further comprises:
providing a new cell precursor having the film layer to be grooved;
providing the laser transfer printing substrate on which fabrication of one of the grid lines of the cell precursor has been completed using the slurry in the first transfer printing area and which is in an available state;
aligning the center line of one of the conductive plate portions in the second transfer printing area of the laser transfer printing substrate in the available state with the center line of one of the areas to be grooved in the new cell precursor; and
repeating the steps of performing laser grooving and performing grid line transfer printing till fabrication of all the grid lines corresponding to the areas to be grooved in the film layer to be grooved of the new cell precursor is completed.

11. The preparation method according to claim 10, wherein the preparation method further comprises:
determining whether the filling groove is filled with the slurry in each of the second transfer printing areas of the laser transfer printing substrate, if it is determined that the filling groove is still filled with the slurry, the laser transfer printing substrate is still in the available state and is continued to be used to fabricate the grid lines of the new cell precursor, and if it is determined that the filling groove is not filled with the slurry , the laser transfer printing substrate is replaced.

12. The preparation method according to claim 1, wherein
in the step of providing a laser transfer printing substrate, in a direction in which the filling groove protrudes, the notch size of the filling groove is greater than or equal to the sizes of the other positions of the filling groove.

13. The preparation method according to claim 11, wherein
the cross-sectional shape of the filling groove is selected from any of a trapezoid, a rectangle and a triangle.

14. The preparation method according to claim 1, wherein
in the step of providing a laser transfer printing substrate, the filling groove is continuously filled with the slurry, and in the step of performing laser grooving, the notch is a continuous notch.

15. The preparation method according to claim 1, wherein
in the step of providing a laser transfer printing substrate, the filling groove is intermittently filled with the slurry, and in the step of performing laser grooving, the notch is an intermittent notch.

## Patentansprüche

1. Herstellungsverfahren für eine Gitterlinie einer Solarzelle, umfassend:
Bereitstellen eines Zellvorläufers mit einer zu ritzenden Filmschicht (31), die zu ritzende Bereiche zum Bilden von Gitterlinien (21) umfasst, wobei die Mehrzahl von zu ritzenden Bereichen in Abständen angeordnet ist, und zwar um einen Abstand D zwischen den jeweiligen Mittellinien derselben;
Bereitstellen eines Laser-Transferdrucksubstrats (10), das eine Mehrzahl von ersten Transferdruckbereichen (A) umfasst, die in Abständen um einen Abstand k angeordnet sind, wobei k gleich D-d ist, k>0, jeder der ersten Transferdruckbereiche einen leitfähigen Plattenabschnitt (11) und eine Füllnut (12) aufweist, die miteinander verbunden sind und beide eine Breite d aufweisen, und die Füllnut mit einer Paste (20) gefüllt ist und so angeordnet ist, dass sie relativ zu einer Ebene, in der der leitfähige Plattenabschnitt liegt, hervorsteht;
Ausrichten der Mittellinie eines der leitfähigen Plattenabschnitte mit der Mittellinie eines der zu ritzenden Bereiche;
Durchführen eines Laserritzens, wobei ein von einer Laservorrichtung (40) emittierter erster Laserstrahl den zu ritzenden Bereich über den leitfähigen Plattenabschnitt ritzt, um in der zu ritzenden Filmschicht eine Rille (311) mit einer Breite d zu bilden, wobei der Zellvorläufer und das Laser-Transferdrucksubstrat in einer Laseraussendungsrichtung (Z) in Abständen parallel zueinander angeordnet sind;
Durchführen eines Gitterlinien-Transferdrucks, wobei das Laser-Transferdrucksubstrat horizontal um einen Abstand d in eine erste Richtung (X) bewegt wird, so dass die Füllnut der Rille entspricht, die Paste in der Füllnut unter Verwendung des von der Laservorrichtung (40) emittierten ersten Laserstrahls auf die Rille übertragen wird, um den Transferdruck einer Gitterlinie zu vervollständigen, und die Laservorrichtung horizontal um einen Abstand D in eine zweite Richtung (Y) bewegt wird; und
Wiederholen der Schritte des Durchführens des Laserritzens und des Durchführens des Gitterlinien-Transferdrucks, bis die Herstellung aller den zu ritzenden Bereichen in der zu ritzenden Filmschicht des Zellvorläufers entsprechenden Gitterlinien abgeschlossen ist, wobei die zweite Richtung der ersten Richtung entgegengesetzt ist und sowohl die erste als auch die zweite Richtung senkrecht zu der Laseraussendungsrichtung sind.

2. Herstellungsverfahren nach Anspruch 1, wobei in dem Schritt des Bereitstellens eines Laser-Transferdrucksubstrats das Laser-Transferdrucksubstrat ferner umfasst:
einen zweiten Transferdruckbereich (B), der zwischen den zwei benachbarten ersten Transferdruckbereichen angeordnet und mit den ersten Transferdruckbereichen verbunden ist, wobei der zweite Transferdruckbereich einen darin vorgesehenen Positionierabschnitt (60) aufweist, der Positionierabschnitt und die Füllnut einander auf beiden Seiten des leitfähigen Plattenabschnitts gegenüberliegend angeordnet und mit dem leitfähigen Plattenabschnitt verbunden sind, und der Positionierabschnitt dazu verwendet wird, die Laserausrichtung zu unterstützen und zu verhindern, dass der Laser auf einen nicht zu ritzenden Bereich der zu ritzenden Filmschicht einwirkt.

3. Herstellungsverfahren nach Anspruch 2, wobei der Schritt (S30) des Ausrichtens der Mittellinie eines der leitfähigen Plattenabschnitte mit der Mittellinie eines der zu ritzenden Bereiche umfasst:
Anordnen von Referenzmarken an beiden Seitenrändern des zu ritzenden Bereichs und Erfassen von Positionsinformationen des zu ritzenden Bereichs gemäß den Referenzmarken;
Steuern der Laservorrichtung zum Bewegen relativ zu dem Zellvorläufer gemäß den Positionsinformationen des zu ritzenden Bereichs, bis ein von der Laservorrichtung emittierter zweiter Laserstrahl einen der zu ritzenden Bereiche abdeckt, wobei die Ausrichtung der Laservorrichtung mit einem der zu ritzenden Bereiche in dem Zellvorläufer abgeschlossen ist, die Strahlbreiten des ersten Laserstrahls und des zweiten Laserstrahls gleich der Breite des zu ritzenden Bereichs sind, die Leistung des ersten Laserstrahls größer als die Leistung des zweiten Laserstrahls ist und der zweite Laserstrahl nicht auf die zu ritzende Filmschicht einwirkt; und
Positionieren eines der leitfähigen Plattenabschnitte in dem Laser-Transferdrucksubstrat zwischen der Laservorrichtung und dem Zellvorläufer, gleichzeitiges Emittieren des von der Laservorrichtung emittierten zweiten Laserstrahls durch das Laser-Transferdrucksubstrat, und Steuern des Laser-Transferdrucksubstrats zum Bewegen relativ zu dem Zellvorläufer gemäß einer Laserdurchlässigkeit eines Bereichs oberhalb des mit der Laservorrichtung ausgerichteten zu ritzenden Bereichs und/oder einem Laserreflexionsvermögen zwischen dem Laser-Transferdrucksubstrat und der Laservorrichtung, bis die Mittellinie eines der leitfähigen Plattenabschnitte mit der Mittellinie eines der zu ritzenden Bereiche ausgerichtet ist.

4. Herstellungsverfahren nach Anspruch 2, wobei
der zweite Transferdruckbereich ferner einen verbindenden Plattenabschnitt (62) umfasst, der den Positionierabschnitt und die Füllnut in dem benachbarten ersten Transferdruckbereich verbindet.

5. Herstellungsverfahren nach einem der Ansprüche 2 bis 4, wobei
der Positionierabschnitt ein Laserschutzmaterial umfasst.

6. Herstellungsverfahren nach einem der Ansprüche 2 bis 4, wobei
der Positionierabschnitt eine Laserschutzschicht (63) umfasst, die eine Grundplatte des Laser-Transferdrucksubstrats bedeckt.

7. Herstellungsverfahren nach einem der Ansprüche 2 bis 4, wobei
der Positionierabschnitt eine Begrenzungsnut (61) umfasst, die so angeordnet ist, dass sie relativ zu dem leitfähigen Plattenabschnitt hervorsteht, und eine hervorstehende Oberfläche der Begrenzungsnut mit einer Laserreflexionsschicht bedeckt ist.

8. Herstellungsverfahren nach Anspruch 2, wobei
der Positionierabschnitt die mit der Paste gefüllte Füllnut ist, der zweite Transferdruckbereich ferner einen leitfähigen Plattenabschnitt umfasst, und eine Mehrzahl von leitfähigen Plattenabschnitten und mit der Paste gefüllten Füllnuten in dem zweiten Transferdruckbereich abwechselnd angeordnet sind, wobei D=(2n+1)×d ist und n eine positive ganze Zahl größer als 1 ist.

9. Herstellungsverfahren nach Anspruch 8, wobei der Wertebereich von d 5 µm-80 µm ist.

10. Herstellungsverfahren nach Anspruch 8, wobei das Herstellungsverfahren, nachdem die Herstellung aller den zu ritzenden Bereichen in der zu ritzenden Filmschicht des Zellvorläufers entsprechenden Gitterlinien abgeschlossen ist, ferner umfasst:
Bereitstellen eines neuen Zellvorläufers mit der zu ritzenden Filmschicht;
Bereitstellen des Laser-Transferdrucksubstrats, bei dem die Herstellung einer der Gitterlinien des Zellvorläufers unter Verwendung der Paste in dem ersten Transferdruckbereich abgeschlossen worden ist und das sich in einem verfügbaren Zustand befindet;
Ausrichten der Mittellinie eines der leitfähigen Plattenabschnitte in dem zweiten Transferdruckbereich des Laser-Transferdrucksubstrats in dem verfügbaren Zustand mit der Mittellinie eines der zu ritzenden Bereiche in dem neuen Zellvorläufer; und
Wiederholen der Schritte des Durchführens des Laserritzens und des Durchführens des Gitterlinien-Transferdrucks, bis die Herstellung aller den zu ritzenden Bereichen in der zu ritzenden Filmschicht des neuen Zellvorläufers entsprechenden Gitterlinien abgeschlossen ist.

11. Herstellungsverfahren nach Anspruch 10, wobei das Herstellungsverfahren ferner umfasst:
Bestimmen, ob die Füllnut in jedem der zweiten Transferdruckbereiche des Laser-Transferdrucksubstrats mit der Paste gefüllt ist, wenn bestimmt wird, dass die Füllnut noch mit der Paste gefüllt ist, sich das Laser-Transferdrucksubstrat noch in dem verfügbaren Zustand befindet und weiterhin verwendet wird, um die Gitterlinien des neuen Zellvorläufers herzustellen, und wenn bestimmt wird, dass die Füllnut nicht mit der Paste gefüllt ist, das Laser-Transferdrucksubstrat ersetzt wird.

12. Herstellungsverfahren nach Anspruch 1, wobei
in dem Schritt des Bereitstellens eines Laser-Transferdrucksubstrats in einer Richtung, in der die Füllnut hervorsteht, die Nutgröße der Füllnut größer als oder gleich den Größen der anderen Positionen der Füllnut ist.

13. Herstellungsverfahren nach Anspruch 11, wobei
die Querschnittsform der Füllnut aus einem Trapez, einem Rechteck und einem Dreieck ausgewählt ist.

14. Herstellungsverfahren nach Anspruch 1, wobei
in dem Schritt des Bereitstellens eines Laser-Transferdrucksubstrats die Füllnut kontinuierlich mit der Paste gefüllt ist, und in dem Schritt des Durchführens des Laserritzens die Rille eine kontinuierliche Rille ist.

15. Herstellungsverfahren nach Anspruch 1, wobei
in dem Schritt des Bereitstellens eines Laser-Transferdrucksubstrats die Füllnut intermittierend mit der Paste gefüllt ist, und in dem Schritt des Durchführens des Laserritzens die Rille eine intermittierende Rille ist.

## Revendications

1. Procédé de préparation d'une ligne de grille de cellule solaire, comprenant :
fournir un précurseur de cellule ayant une couche de film (31) à rainurer, qui comprend des zones à rainurer pour former des lignes de grille (21), la pluralité de zones à rainurer étant agencée à intervalles espacés d'une distance D entre leurs lignes centrales respectives ;
fournir un substrat d'impression par transfert laser (10), qui comprend une pluralité de premières zones d'impression par transfert (A) agencées à intervalles espacés d'une distance k, dans lequel k est égal à D-d, k>0, chacune des premières zones d'impression par transfert comporte une portion de plaque conductrice (11) et une rainure de remplissage (12) qui sont reliées l'une à l'autre et ont toutes deux une largeur d, et la rainure de remplissage est remplie d'une pâte (20) et est agencée pour faire saillie par rapport à un plan dans lequel la portion de plaque conductrice est située ;
aligner la ligne centrale de l'une des portions de plaque conductrice avec la ligne centrale de l'une des zones à rainurer ;
effectuer un rainurage laser, dans lequel un premier faisceau laser émis par un dispositif laser (40) rainure la zone à rainurer via la portion de plaque conductrice de manière à former une rainure (311) ayant une largeur d dans la couche de film à rainurer, le précurseur de cellule et le substrat d'impression par transfert laser étant agencés à intervalles parallèlement l'un à l'autre dans une direction d'émission laser (Z) ;
effectuer une impression par transfert de ligne de grille, dans lequel le substrat d'impression par transfert laser est déplacé horizontalement d'une distance d dans une première direction (X) de sorte que la rainure de remplissage corresponde à la rainure, la pâte dans la rainure de remplissage étant transférée dans la rainure au moyen du premier faisceau laser émis par le dispositif laser (40) de manière à achever l'impression par transfert d'une ligne de grille, et le dispositif laser étant déplacé horizontalement d'une distance D dans une deuxième direction (Y) ; et
répéter les étapes consistant à effectuer le rainurage laser et à effectuer l'impression par transfert de ligne de grille jusqu'à ce que la fabrication de toutes les lignes de grille correspondant aux zones à rainurer dans la couche de film à rainurer du précurseur de cellule soit achevée, dans lequel la deuxième direction est opposée à la première direction, et les première et deuxième directions sont toutes deux perpendiculaires à la direction d'émission laser.

2. Procédé de préparation selon la revendication 1, dans lequel, à l'étape consistant à fournir un substrat d'impression par transfert laser, le substrat d'impression par transfert laser comprend en outre :
une deuxième zone d'impression par transfert (B), qui est située entre les deux premières zones d'impression par transfert adjacentes et reliée aux premières zones d'impression par transfert, dans lequel la deuxième zone d'impression par transfert est pourvue d'une portion de positionnement (60), la portion de positionnement et la rainure de remplissage étant agencées en regard l'une de l'autre de part et d'autre de la portion de plaque conductrice et étant reliées à la portion de plaque conductrice, et la portion de positionnement étant utilisée pour assister l'alignement laser et empêcher le laser d'agir sur une zone de la couche de film à rainurer qui ne doit pas être rainurée.

3. Procédé de préparation selon la revendication 2, dans lequel l'étape (S30) consistant à aligner la ligne centrale de l'une des portions de plaque conductrice avec la ligne centrale de l'une des zones à rainurer comprend :
agencer des repères de référence sur les deux bords latéraux de la zone à rainurer, et acquérir des informations de position de la zone à rainurer conformément aux repères de référence ;
commander le dispositif laser pour se déplacer par rapport au précurseur de cellule conformément aux informations de position de la zone à rainurer jusqu'à ce qu'un deuxième faisceau laser émis par le dispositif laser couvre l'une des zones à rainurer, l'alignement du dispositif laser avec l'une des zones à rainurer dans le précurseur de cellule étant achevé, les largeurs de faisceau du premier faisceau laser et du deuxième faisceau laser étant égales à la largeur de la zone à rainurer, la puissance du premier faisceau laser étant supérieure à la puissance du deuxième faisceau laser, et le deuxième faisceau laser n'agissant pas sur la couche de film à rainurer ; et
placer l'une des portions de plaque conductrice dans le substrat d'impression par transfert laser entre le dispositif laser et le précurseur de cellule, émettre en même temps le deuxième faisceau laser émis par le dispositif laser via le substrat d'impression par transfert laser, et commander le substrat d'impression par transfert laser pour se déplacer par rapport au précurseur de cellule conformément à une transmissivité laser d'une zone au-dessus de la zone à rainurer alignée avec le dispositif laser et/ou à une réflectivité laser entre le substrat d'impression par transfert laser et le dispositif laser jusqu'à ce que la ligne centrale de l'une des portions de plaque conductrice soit alignée avec la ligne centrale de l'une des zones à rainurer.

4. Procédé de préparation selon la revendication 2, dans lequel
la deuxième zone d'impression par transfert comprend en outre une portion de plaque de connexion (62), qui relie la portion de positionnement et la rainure de remplissage dans la première zone d'impression par transfert adjacente.

5. Procédé de préparation selon l'une quelconque des revendications 2 à 4, dans lequel
la portion de positionnement comprend un matériau de protection laser.

6. Procédé de préparation selon l'une quelconque des revendications 2 à 4, dans lequel
la portion de positionnement comprend une couche de protection laser (63) recouvrant une plaque de base du substrat d'impression par transfert laser.

7. Procédé de préparation selon l'une quelconque des revendications 2 à 4, dans lequel
la portion de positionnement comprend une rainure de limitation (61), qui est agencée pour faire saillie par rapport à la portion de plaque conductrice, et la surface saillante de la rainure de limitation est recouverte d'une couche de réflexion laser.

8. Procédé de préparation selon la revendication 2, dans lequel
la portion de positionnement est la rainure de remplissage remplie de la pâte, la deuxième zone d'impression par transfert comprend en outre la portion de plaque conductrice, et une pluralité de portions de plaque conductrice et de rainures de remplissage remplies de la pâte sont agencées en alternance dans la deuxième zone d'impression par transfert, dans lequel D=(2n+1)×d, et n est un entier positif supérieur à 1.

9. Procédé de préparation selon la revendication 8, dans lequel la plage de valeurs de d est de 5 µm-80 µm.

10. Procédé de préparation selon la revendication 8, dans lequel, après que la fabrication de toutes les lignes de grille correspondant aux zones à rainurer dans la couche de film à rainurer du précurseur de cellule est achevée, le procédé de préparation comprend en outre :
fournir un nouveau précurseur de cellule ayant la couche de film à rainurer ;
fournir le substrat d'impression par transfert laser sur lequel la fabrication de l'une des lignes de grille du précurseur de cellule a été achevée en utilisant la pâte dans la première zone d'impression par transfert et qui est dans un état disponible ;
aligner la ligne centrale de l'une des portions de plaque conductrice dans la deuxième zone d'impression par transfert du substrat d'impression par transfert laser dans l'état disponible avec la ligne centrale de l'une des zones à rainurer dans le nouveau précurseur de cellule ; et
répéter les étapes consistant à effectuer le rainurage laser et à effectuer l'impression par transfert de ligne de grille jusqu'à ce que la fabrication de toutes les lignes de grille correspondant aux zones à rainurer dans la couche de film à rainurer du nouveau précurseur de cellule soit achevée.

11. Procédé de préparation selon la revendication 10, dans lequel le procédé de préparation comprend en outre :
déterminer si la rainure de remplissage est remplie de la pâte dans chacune des deuxièmes zones d'impression par transfert du substrat d'impression par transfert laser, si l'on détermine que la rainure de remplissage est encore remplie de la pâte, le substrat d'impression par transfert laser est encore dans l'état disponible et continue à être utilisé pour fabriquer les lignes de grille du nouveau précurseur de cellule, et si l'on détermine que la rainure de remplissage n'est pas remplie de la pâte, le substrat d'impression par transfert laser est remplacé.

12. Procédé de préparation selon la revendication 1, dans lequel
à l'étape consistant à fournir un substrat d'impression par transfert laser, dans une direction dans laquelle la rainure de remplissage fait saillie, la taille d'encoche de la rainure de remplissage est supérieure ou égale aux tailles des autres positions de la rainure de remplissage.

13. Procédé de préparation selon la revendication 11, dans lequel
la forme en section transversale de la rainure de remplissage est sélectionnée parmi l'un quelconque d'un trapèze, d'un rectangle et d'un triangle.

14. Procédé de préparation selon la revendication 1, dans lequel
à l'étape consistant à fournir un substrat d'impression par transfert laser, la rainure de remplissage est remplie de manière continue de la pâte, et à l'étape consistant à effectuer le rainurage laser, la rainure est une rainure continue.

15. Procédé de préparation selon la revendication 1, dans lequel
à l'étape consistant à fournir un substrat d'impression par transfert laser, la rainure de remplissage est remplie de manière intermittente de la pâte, et à l'étape consistant à effectuer le rainurage laser, la rainure est une rainure intermittente.
